# FASCICULE DE BREVET EUROPEEN

(11) **EP 1 500 191 B1**
(45) Date de publication et mention de la délivrance du brevet: **05.10.2005**
(21) Numéro de dépôt: 03752668.8
(22) Date de dépôt: 11.03.2003
(51) Int. Cl.: H03H 9/02

(54) **DISPOSITIF A ONDES ACOUSTIQUES D' INTERFACE EN TANTALATE DE LI THIUM**
BAUELEMENT MIT GRENZFLÄCHENSCHALLWELLEN AUS LITHIUMTANTALAT
DEVICE WITH INTERFACE SOUND WAVES MADE OF LITHIUM TANTALATE

(30) Priorité: 19.03.2002 FR 0203385
(43) Date de publication de la demande: 26.01.2005
(73) Titulaire: Thales, 75008 Paris (FR)
(72) Inventeur: SOLAL, Marc THALES Intellectual Property, F-94117 Arcueil Cedex (FR); CALISTI, Serge THALES Intellectual Property, F-94117 Arcueil cedex (FR); LAUDE, Vincent THALES Intellectual Property, F-94117 Arcueil Cedex (FR); BALLANDRAS, Sylvain THALES Intellectual Property, F-94117 Arcueil Cedex (FR); CAMOU, Serge THALES Intellectual Property, F-94117 Arcueil cedex (FR); PASTUREAUD, Thomas THALES Intellectual Property, F-94117 Arcueil cedex (FR)
(74) Mandataire: Esselin, Sophie
(86) Numéro de dépôt international: PCT/FR2003/000779
(87) Numéro de publication internationale: WO 2003/098800

(56) Documents cités:
- FR-A- 2 145 750
- FR-A- 2 799 906
- PATENT ABSTRACTS OF JAPAN vol. 1999, no. 03, 31 mars 1999 (1999-03-31) & JP 10 335974 A (MATSUSHITA ELECTRIC IND CO LTD), 18 décembre 1998 (1998-12-18)

## Description

Le domaine de l'invention est celui des dispositifs à ondes acoustiques d'interface et notamment celui des filtres, réalisés à l'interface de deux substrats en Tantalate de Lithium.

Il est connu de réaliser des dispositifs à ondes acoustiques de surface qui utilisent la propagation d'ondes à la surface d'un substrat piézoélectrique. Dans le cas des ondes dites de Rayleigh, la génération et la réception des ondes sont assurées par des transducteurs à peignes interdigités composés d'électrodes entrelacées entre lesquelles on impose une différence de potentiel. Ces dispositifs présentent deux inconvénients principaux :

D'une part, pour que les ondes de surface se propagent correctement à la surface du substrat, cette surface doit rester libre. Cette condition est obtenue par des technologies d'encapsulation permettant d'obtenir une cavité.

D'autre part, le pas des électrodes composant les peignes interdigités est souvent faible, de l'ordre de quelques centaines de nanomètres. Aussi, des particules conductrices de très faibles dimensions présentes à l'intérieur du boîtier peuvent court-circuiter un transducteur et perturber le fonctionnement normal du dispositif. Pour pallier cet inconvénient, il faut, soit rendre les boîtiers des composants hermétiques, soit déposer sur les transducteurs une fine couche de matériau diélectrique isolant. Cette opération appelée passivation permet de supprimer la sensibilité aux particules conductrices. Elle ne permet néanmoins pas d'éliminer l'opération d'encapsulation qui est une opération coûteuse à réaliser.

L'utilisation de dispositifs à ondes acoustiques d'interface permet de résoudre les différents problèmes liés à l'encapsulation. On utilise, dans ce cas, non plus la propagation des ondes acoustiques à la surface du substrat mais à l'interface entre deux substrats. Ce dispositif permet d'obtenir naturellement un composant passivé ne nécessitant plus de réalisation de cavité. D'autre part, le boîtier peut être complétement supprimé.

En 1924, Stoneley a montré la possibilité de guider une onde acoustique à l'interface entre deux matériaux [proc. Roy. Soc. London A 106, 416]. Ces ondes étaient considérées comme étant polarisées dans le plan sagittal.

En 1971, Maerfeld et Tournois ont démontré l'existence d'ondes de cisaillement horizontal se propageant à l'interface entre deux matériaux. Le cas piézoélectrique était considéré [C. Maerfeld, P. Tournois, Appl. Phys. Lett. 19, 117, 1971]. Une premiére utilisation de ce type d'onde pour des composants acoustiques est divulgué dans le brevet FR2145750. L'invention décrite utilise la propagation d'ondes de cisaillement pur à l'interface entre deux matériaux dont un au moins est piézoelectrique. Le cas où les deux matériaux sont identiques est considéré. Ce brevet ne fait cependant pas mention de transducteurs placés à l'interface entre les deux matériaux.

En 1983, la propagation d'ondes à l'interface entre un matériau piezoélectrique et un matériau isotrope dans le but de réaliser des dispositifs SAW sans boîtier est décrite, ce qui suppose, de façon implicite, que les transducteurs sont placés à l'interface. D'autre part, le coefficient de couplage est étudié [Shimitzu et al. Stoneley waves propagating along an interface between piezoelectric materia! and isotropic material, 1983 IEEE US proc pp 373-375].

Plus récemment, en 1998, une combinaison différente de matériau en vue de faire du filtrage a été examinée [M. Yamaguchi, T. Yamashita, K. Hashimoto, T. Omori, Highly Piezoelectric Waves in Si/SiO2/LiNbO3 and Si/SiO2/LiNBO3 structures, unpublished].

Enfin, en 1999, le brevet FR 2 799 906 décrivait des filtres utilisant des transducteurs à l'interface entre deux matériaux piézoélectriques identiques.

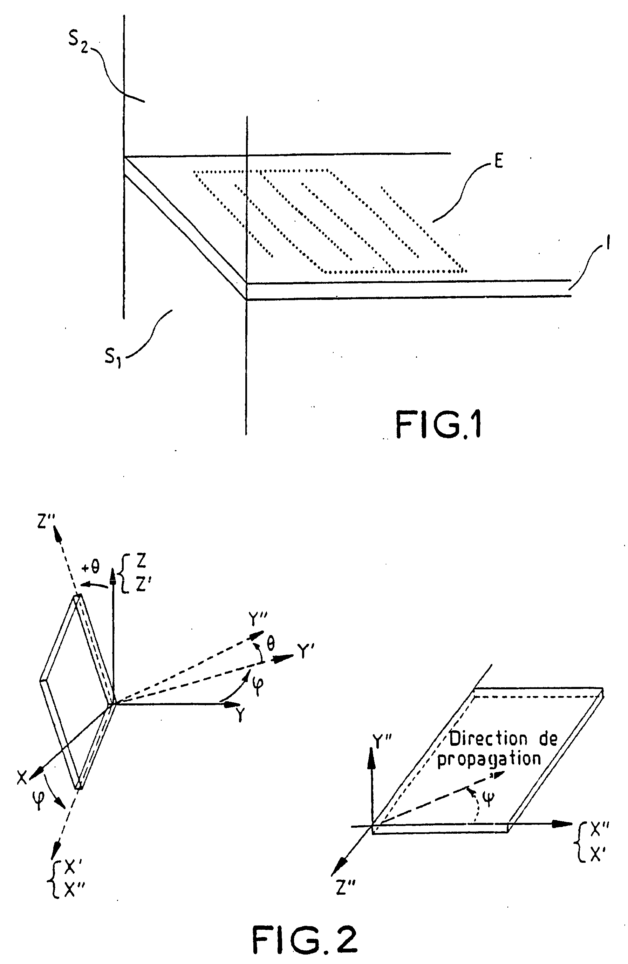

De façon générale, un dispositif à ondes acoustiques d'interface est constitué de deux substrats notés S₁ et S₂, dont l'un au moins est piézoélectrique et d'une zone d'interface I située entre ces deux substrats comme il est indiqué sur la figure 1. Dans le cas général, La zone d'interface I est une structure qui comprend au moins les dispositifs de transduction électro-acoustiques E. Des interconnexions électriques couplées auxdits dispositifs permettent l'émission et la transmission des signaux.

Les ondes d'interface sont utilisables pour réaliser des composants passifs. De façon générale, tout type de dispositif obtenu à l'aide d'ondes se propageant à la surface d'un cristal peut être réalisé en utilisant des ondes d'interface. En particulier, il est possible de réfléchir les ondes d'interface à l'aide de réseaux d'électrodes métalliques de période égale à une demi-longueur d'onde placé à l'interface. On réalise ainsi, d'abord un résonateur en plaçant un transducteur interdigité entre deux réseaux réflecteurs et ensuite un filtre en couplant des résonateurs entre eux par des moyens électriques ou acoustiques. On améliore la directivité d'un transducteur en y intercalant des réflecteurs. Toutes les applications des composants à ondes de surface sont alors accessibles, notamment les lignes à retard, les filtres de bande, les résonateurs et les filtres dispersifs. Les applications de ces composants en tant que capteurs de mesure sont également possibles.

Les dispositifs à code de phase possèdent des dispositifs de transduction spécifiques caractérisés par une répartition des électrodes telle que l'on sait associer un code particulier à un composant à code de phase donné. Les dispositifs interrogeables à distance par onde radio utilisent ce principe. Le fonctionnement est le suivant : un code de phase est utilisé à l'émission de l'onde, l'onde est captée par une antenne reliée à l'entrée du composant à code de phase ; de façon classique, le transducteur convertit le signal en onde mécanique. Ladite onde se propage jusqu'au tranducteur de sortie où elle est alors reconvertie en signal électrique et réémise. Le signal reçu est analysé et le composant qui a reçu et transformé le signal est ainsi identifié.

Les dispositifs à ondes d'interface peuvent être utilisés en tant que dispositifs interrogeables à distance, notamment pour les applications de mesure comme la mesure de pression, de température ou d'accéleration.

Le choix des structures des composants à ondes d'interface peut être très varié. On citera notamment les associations suivantes :
- Le substrat S₁ est piézoélectrique et S₂ ne l'est pas. Dans ce cas, on choisit S₂ en fonction de ses propriétés mécaniques de façon à faciliter la réalisation des composants. Par exemple, si S₁ est du Niobate de Lithium ou du Tantalate de Lithium, S₂ sera préférentiellement de la silice fondue ou du silicium mono cristallin.
- Les deux substrats sont tous deux piézoélectriques mais de nature différente. On citera, par exemple, les associations suivantes :
   - Quartz - Niobate de Lithium
   - Quartz - Tantalate de Lithium
   - Tantalate de Lithium - Niobate de Lithium
- Les deux substrats sont de même nature mais de coupe cristalline différente. La figure 2 représente, suivant les conventions IEEE 1949 dans le repère orthonormé initial (X, Y, Z) avec Z parallèle à l'axe optique du cristal, X défini par la piézoélectricité du cristal et Y perpendiculaire à (X,Z) la représentation géométrique du plan de coupe définie par deux angles de rotation successifs ϕ et θ. ϕ correspond à une première rotation autour de l'axe Z, le repère obtenu ainsi est noté (X', Y', Z') avec Z' confondu avec Z, θ correspond à une seconde rotation autour de l'axe X', le repère obtenu ainsi est noté (X", Y", Z"), avec X" confondu avec X'. Dans ce repère final, la direction de propagation des ondes acoustiques est alors définie par un troisième angle ψ représentant une rotation autour de l'axe Y". A titre d'exemple, avec ces conventions, les valeurs des angles pour les coupes habituellement utilisées en ondes de surface pour le quartz ST sont les suivantes :
   - ϕ = 0°, θ = 42.75°, ψ = 0°.
- Enfin, les deux substrats peuvent être de même nature et de même coupe. On peut utiliser, par exemple, du quartz, du Niobate de Lithium ou du Tantalate de Lithium. Dans ce cas, en règle générale, l'assemblage se fera suivant la même orientation cristalline des deux substrats.

Ce dernier cas est particulièrement intéressant dans la mesure où les problèmes de compatibilité entre les substrats S₁ et S₂, en particulier les problèmes de dilatation thermique ou d'assemblage sont résolus implicitement. Dans ce cas, les orientations des faces des cristaux sont choisies afin d'obtenir des polarisations de même direction.

Quatre caractéristiques majeures définissent les propriétés de propagation des ondes acoustiques des matériaux piézoélectriques. Ce sont:
- La vitesse V de propagation de l'onde acoustique d'interface. Ce paramètre est important dans la mesure où pour une fréquence d'utilisation donnée F, il conditionne le pas P du réseau des dents des peignes d'électrodes proportionnel à V/F.
   Lorsque l'on travaille à haute fréquence, typiquement de l'ordre de quelques GHz, l'obtention de vitesses élevées permet de garder des pas suffisamment larges compatibles des technologies actuelles de gravure ;
- L'atténuation A ou perte d'insertion exprimée en dB par longueur d'onde acoustique, paramètre que l'on cherche, en général, à diminuer de façon à réduire les pertes d'insertion du dispositif ;
- Le coefficient CFT du premier ordre de la variation de fréquence en fonction de la température au voisinage de la température ambiante exprimé en ppm.C⁻¹. La configuration du dispositif sera d'autant plus insensible aux variations thermiques que ce coefficient sera faible ;
- Le coefficient de couplage électromécanique K² représentatif de la bande de fréquence relative maximale que l'on peut obtenir avec un dispositif et calculé comme le demi-écart relatif des vitesses des ondes de surface sur le substrat libre et le substrat métallisé. Ce coefficient est, de façon générale, le paramètre que l'on cherche à maximiser. K² est un paramètre sans dimensions exprimé en pour cent.

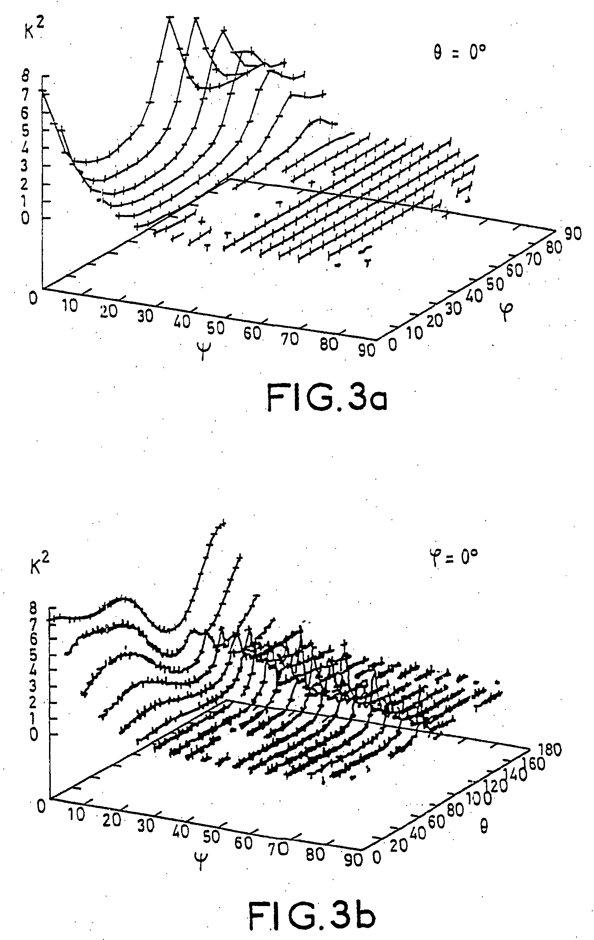

Ces différents paramètres, et en particulier le coefficient de couplage K² dépendent fortement de l'angle de coupe du cristal piézoélectrique et de la direction de propagation. On peut ainsi obtenir suivant l'angle de coupe pour le Tantalate de Lithium des valeurs de K² variant entre 0 et 7 comme il est indiqué sur les figures 3a et 3b. La figure 3a représente la variation de K² en fonction de (ϕ, ψ) à θ nul et la figure 3b représente la variation de K² en fonction de (θ, ψ) à ϕ nul. Sur ces figures, les discontinuités représentent les zones à l'intérieur desquelles il n'existe pas de mode de propagation possible. Le choix de l'angle de coupe est donc fondamental. Or, les variations des caractéristiques acoustiques en fonction de cet angle ne peuvent se déterminer simplement, par exemple par des considérations sur la structure cristalline. Elles sont également très différentes de celles que l'on obtient pour des matériaux libres utilisés pour les ondes acoustiques de surface.

Le brevet 2 799 906 de Pierre Tournois concernant la réalisation de filtres à ondes acoustiques d'interface donne quelques recommandations générales citées à titre d'exemple permettant de choisir des angles de coupe optimaux. Il est notamment cité dans le cas de l'utilisation du Tantalate de Lithium que les coupes peuvent être prises suivant l'axe cristallographique Y (où Y est tourné d'un certain angle par exemple 175 °).

L'invention propose, quant à elle, une sélection de plages d'angles de coupe optimisés. En effet, elle donne précisément les tolérances sur les angles de coupe ; l'ensemble des angles de coupe optimaux permettant d'obtenir, dans le cas du Tantalate de Lithium, les meilleures caractéristiques possibles, en particulier les valeurs les plus élevées du paramètre K² ; et enfin les valeurs des caractéristiques principales, permettant d'atteindre les performances attendues.

Les différentes étapes de réalisation des composants sont également décrites.

Dans ce contexte, l'invention a pour objet un dispositif à ondes acoustiques d'interface comprenant :
- un premier substrat cristallin en Tantalate de Lithium (LiTaO₃) ;
- un second substrat cristallin également en Tantalate de Lithium ;
- assemblés par une zone d'interface plane servant à la propagation des ondes acoustiques et comprenant au moins les dispositifs de transduction électroacoustiques ;
- des moyens d'interconnexion permettant de raccorder électriquement lesdits dispositifs de transduction ;
les substrats, référencés dans un repère orthonormé initial (X, Y, Z) avec Z parallèle à l'axe optique, X défini par la piézoélectricité du cristal et Y perpendiculaire à (X, Z), ayant leur plan de coupe identique et une orientation cristalline commune, ledit plan de coupe étant identifié par deux angles de rotation successifs ϕ et θ, ϕ correspondant à une première rotation autour de l'axe Z, le repère obtenu ainsi étant noté (X', Y', Z') avec Z' confondu avec Z, θ représentant une seconde rotation autour de l'axe X', le repère obtenu ainsi étant noté (X", Y", Z"), avec X" confondu avec X' ; la direction de propagation des ondes acoustiques étant définie par un troisième angle ψ pris dans ledit repère (X", Y", Z") représentant une rotation autour de l'axe Y", caractérisé en ce que, pour toute direction de propagation ψ :
les angles (ϕ, θ) sont compris dans l'une des deux plages angulaires suivantes appelées coupe (0, 0, 0)ₐ et coupe (60, 0, 0)ₐ :
   - coupe (0, 0, 0)ₐ - 5° ≤ ϕ ≤ + 5°
      - 20° ≤ θ ≤ + 30°
   - coupe (60, 0, 0)ₐ + 55° ≤ ϕ ≤ + 65°
      - 30° ≤ θ ≤ + 20°

Avantageusement, de façon à obtenir les valeurs maximales du coefficient de couplage et à diminuer les pertes d'insertion, il est préférable de travailler dans des plages angulaires restreintes. Dans ce cas, les angles (ϕ, θ, ψ), pris dans le repère (X", Y", Z"), sont compris dans l'une des deux plages angulaires suivantes appelées coupe (0, 0, 0)_{b} et coupe (60, 0, 0)_{b} :
- coupe (0, 0, 0)_{b} - 5° ≤ ϕ ≤ + 5°
   - 10° ≤ θ ≤ +10°
   -5° ≤ ψ ≤ +5°
- coupe (60, 0, 0)_{b} + 55° ≤ ϕ ≤ + 65°
   - 10° ≤ θ ≤ +10°
   -5° ≤ ψ ≤ +5°

Avantageusement, les épaisseurs des deux substrats sont grandes devant la longueur d'onde acoustique d'utilisation (λ). Dans ces conditions, les ondes acoustiques restent confinées à l'intérieur des deux substrats, ce qui empêche toute perturbation possible de l'extérieur. L'épaisseur de la zone d'interface est, à l'inverse, choisie faible devant cette même longueur d'onde acoustique d'utilisation afin que les perturbations introduites par les caractéristiques mécaniques propres de ladite zone soient négligeables.

Avantageusement, la zone d'interface se présente sous la forme d'une structure stratifiée comprenant au moins les dispositifs de transduction électro-acoustiques ainsi qu'une ou plusieurs couches de matériau diélectrique. Les principaux avantages de ces couches sont de faciliter soit la propagation des ondes, soit l'adhérence du second substrat sur la zone d'interface.

Avantageusement, la zone d'interface comprend uniquement les dispositifs de transduction électro-acoustiques qui sont alors gravés sur une des deux surfaces des substrats en contact, ladite zone d'interface étant alors réduite à un plan d'interface. Dans ces conditions, l'ensemble des deux substrats et de la zone d'interface une fois assemblés est équivalent à un substrat unique à l'intérieur duquel se trouvent les dispositifs de transduction.

Avantageusement, le dispositif peut être utilisé pour toutes les applications accessibles aux dispositifs à ondes acoustiques de surface, notamment comme composant passif de type résonateur ou filtre ou ligne à retard ou dispositif à code de phase.

Enfin, il est possible de l'utiliser, soit dans une chaîne de mesure, soit dans un ensemble de dispositifs fonctionnant suivant le principe des dispositifs codés comme dispositif interrogeable à distance.

L'invention sera mieux comprise et d'autres avantages apparaîtront à la lecture de la description qui va suivre donnée à titre non limitatif et grâce aux figures annexées parmi lesquelles :
- la figure 1 donne la configuration générale exposée de façon schématique d'un dispositif à ondes d'interface ;
- la figure 2 donne la représentation géométrique de l'angle de coupe définie par les angles ϕ et θ et la représentation de la direction de propagation dans le repère de l'angle de coupe ;
- les figures 3a et 3b donnent les variations de K² en fonction de l'angle de coupe et de la direction de propagation pour le Tantalate de Lithium dans les deux configurations suivantes : θ nul et ϕ nul ;
- les figures 4a et 4b donnent la cartographie des variations du coefficient de couplage K² et de pertes d'insertion en fonction des variations de θ et ϕ pour la coupe (0, 0, 0)ₐ à ψ nul ;
- les figures 5a et 5b donnent la cartographie des variations du coefficient de couplage K² et de pertes d'insertion en fonction des variations de θ et ϕ pour la coupe (60, 0, 0)ₐ à ψ nul ;
- les figures 6a, 6b et 6c donnent les variations du coefficient de couplage K² et des pertes d'insertion au voisinage de la coupe (0, 0, 0)ₐ en fonction des variations d'un des trois angles θ, ϕ et ψ, les deux autres angles étant choisis constants ;
- les figures 7a, 7b et 7c donnent les variations du coefficient de couplage K² et des pertes d'insertion au voisinage de la coupe (60, 0, 0)ₐ en fonction des variations d'un des trois angles θ, ϕ et ψ, les deux autres angles étant choisis constants.

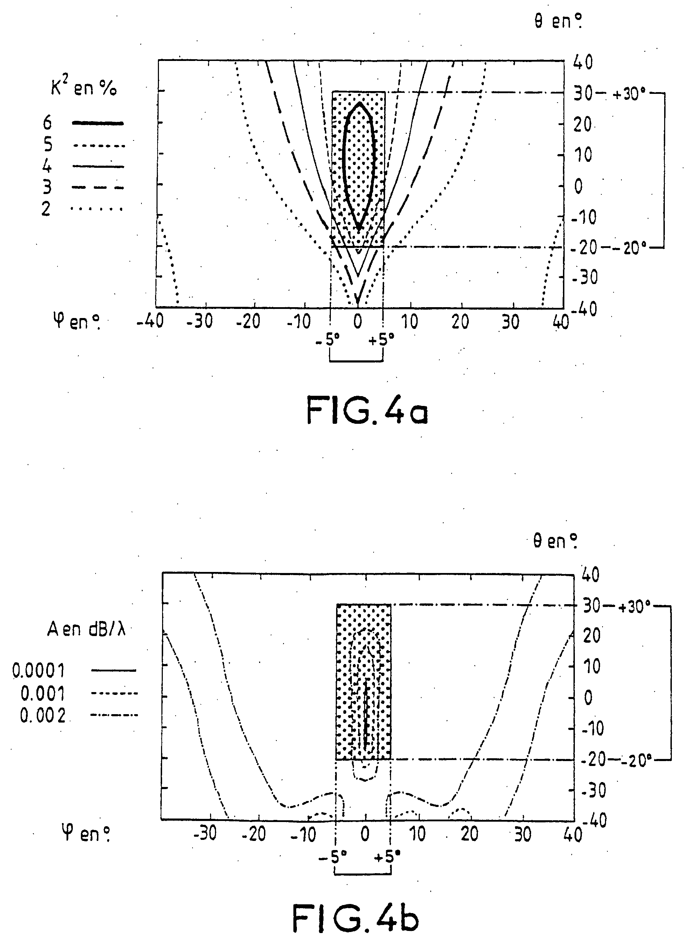

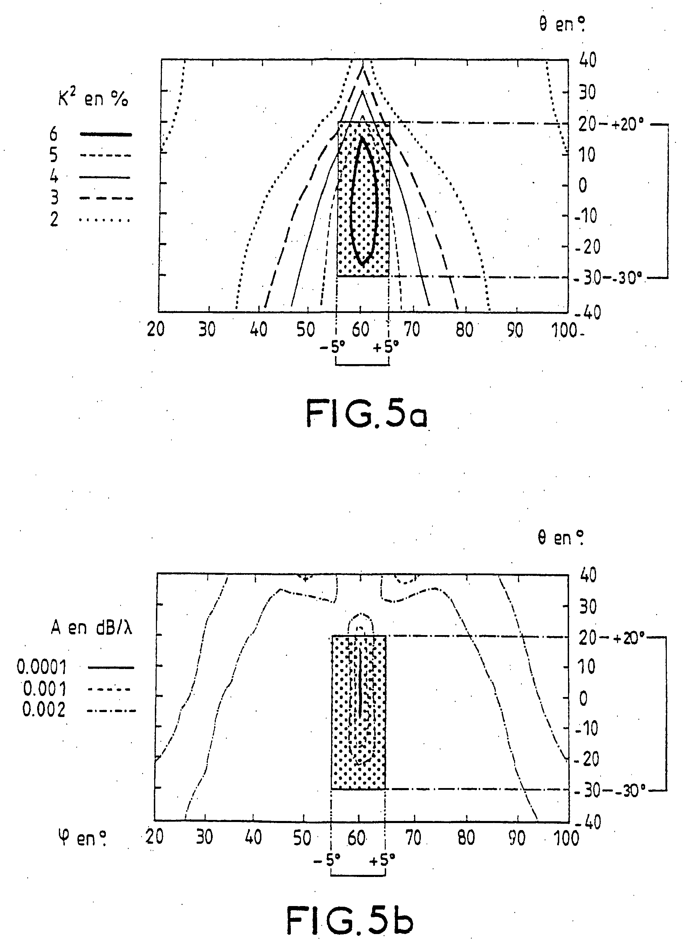

Pour obtenir de bons coefficients de couplage K², typiquement supérieurs à 3% et des atténuations réduites, pour toutes directions de propagation des ondes dans le plan de l'interface, les angles de coupe (ϕ, θ) appartiennent aux plages angulaires suivantes appelées coupe (0, 0, 0)ₐ et coupe (60, 0, 0)ₐ (figures 4a, 4b,5a et 5c) :
- coupe (0, 0, 0)ₐ - 5° ≤ ϕ ≤ + 5°
   - 20° ≤ θ ≤ + 30°
- coupe (60, 0, 0)ₐ + 55° ≤ ϕ ≤ + 65°
   - 30° ≤ θ ≤ + 20°

Pour obtenir des coefficients de couplage K² optimisés typiquement supérieurs à 6% et des atténuations réduites, typiquement inférieures à 2.10⁻³, les angles de coupe (ϕ, θ) et la direction de propagation ψ appartiennent aux plages suivantes appelées coupe (0, 0, 0)_{b} et coupe (60, 0, 0)_{b} (figures 4a, 4b,5a et 5c) :
- coupe (0, 0, 0)_{b} - 5° ≤ ϕ ≤ + 5°
   - 10° ≤ θ ≤ + 10°
   - 5° ≤ ψ ≤ +5°
- coupe (60, 0, 0)_{b} + 55° ≤ ϕ ≤ + 65°
   - 10° ≤ θ ≤ + 10°
   -5° ≤ ψ ≤ +5°

Le tableau ci-dessous donne pour chaque plage l'angle de coupe en coordonnées (ϕ, θ, ψ) permettant d'obtenir la valeur maximale du coefficient de couplage K². Il donne pour cet angle les valeurs des quatre principaux paramètres.

| | Orientation (ϕ, θ, ψ) | K² max.en % | Vitesse en ms⁻¹ | Atténuation en dBλ⁻¹ | CFT en ppmC⁻¹ |
|---|---|---|---|---|---|
| Plage 1 | (0, 0, 0) | 6.8 | 4073 | -3. 10-6 | -22 |
| Plage 2 | (60, 0, 0) | 6.7 | 4073 | -3. 10-6 | -41 |

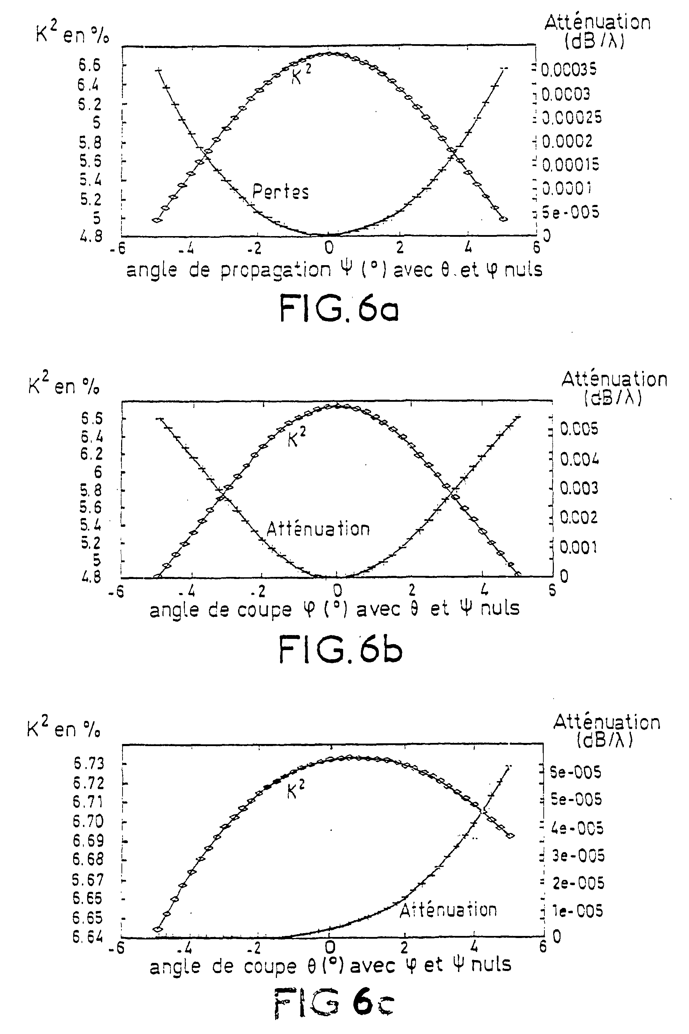

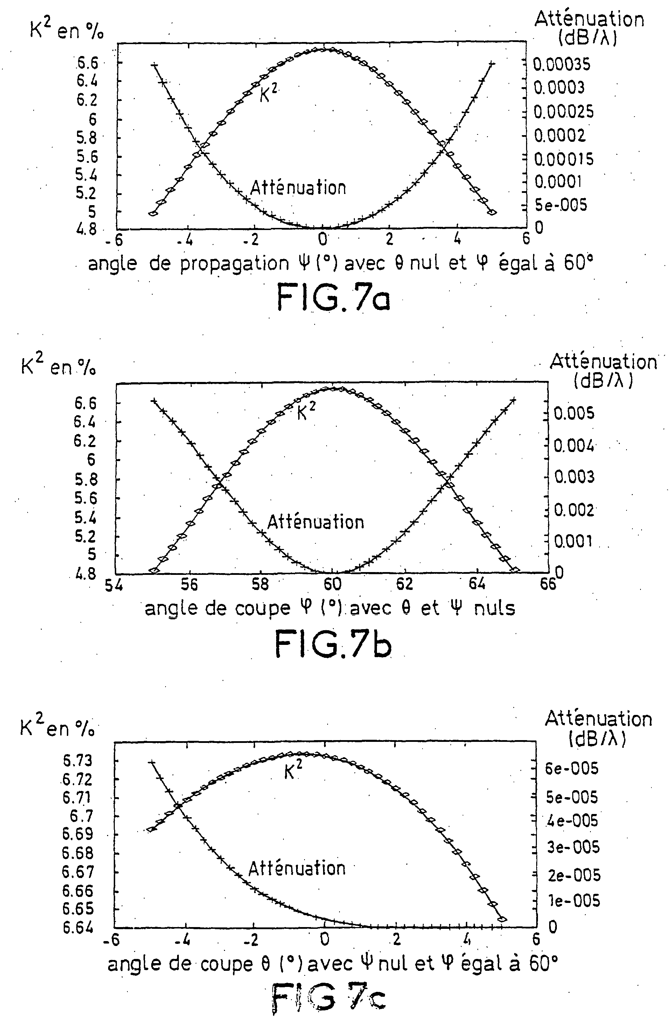

Les variations de K² autour de ces valeurs maximales sont décrites par les figures 6a à 7c.

La réalisation d'un composant à ondes d'interface en Tantalate de Lithium passe par les étapes suivantes :
- Réalisation de la zone d'interface sur un des deux substrats. Cette réalisation comportant nécessairement la sous-étape de réalisation des peignes d'électrodes,
- Assemblage et découpage des deux substrats
- Réalisation des interconnexions électroniques.

La réalisation des peignes d'électrodes se fait soit par un procédé dit des électrodes enterrées, soit par un procédé dit des électrodes déposées.

Dans le premier cas, les principales étapes du procédé sont :
- Réalisation d'une coupe plane du premier substrat en Tantalate de lithium suivant l'angle de coupe retenu,
- Gravure des emplacements des électrodes,
- Dépôt du matériau destiné à réaliser les électrodes, qui peut être de l'aluminium pur ou un alliage d'aluminium permettant de limiter la thermo-migration comme le cuivre titane.
- Planarisation enfin de façon à ne laisser le matériau qu'aux emplacements de gravure.

Dans le second cas, les principales étapes du procédé sont :
- Dépôt sur le substrat plan du matériau destiné à réaliser les électrodes.
- Découpe ensuite de ce matériau pour ne laisser subsister que les électrodes.
- Dépôt d'une couche C intercalaire entre les électrodes,
- Surfaçage de la couche C de façon à obtenir une couche plane de l'épaisseur des électrodes.

Dans une variante de réalisation, on peut commencer par déposer la couche C, réaliser dans cette couche des ouvertures aux emplacements des électrodes, déposer le matériau des électrodes sur cette couche et enfin araser de façon à obtenir le résultat précédent. Si l'épaisseur de la couche est suffisamment faible devant la longueur d'onde acoustique, les caractéristiques électro-acoustiques de l'ensemble ne sont que peu modifiées.

Des couches supplémentaires de matériau diélectrique peuvent ensuite être rapportées pour des raisons technologiques ou acoustiques pour compléter la zone d'interface. Ces couches peuvent notamment faciliter le collage entre les deux substrats. L'épaisseur finale de I doit cependant rester faible devant la longueur d'onde acoustique d'utilisation si l'on souhaite conserver les propriétés dues aux angles de coupe des substrats.

Le second substrat qui a été découpé également dans du Tantalate de lithium suivant le même angle de coupe que le premier substrat est ensuite rapporté sur ledit substrat en fin de procédé de fabrication des électrodes. Cet assemblage peut être fait soit par collage moléculaire soit par soudure anodique. Géométriquement, le second substrat a la même orientation cristalline que le premier.

On réalise ensuite les interconnexions électriques. Il existe plusieurs implantations possibles. On citera, à titre d'exemples non limitatifs :
- Réalisation de l'interconnexion dans le plan de la zone d'interface.
- Réalisation de l'interconnexion à travers un des deux substrats.

## Revendications

1. Dispositif à ondes acoustiques d'interface comprenant :
• un premier substrat cristallin (S₁) en Tantalate de Lithium (LiTaO₃);
• un second substrat cristallin (S₂) également en Tantalate de Lithium ;
• assemblés par une zone d'interface plane (I) servant à la propagation des ondes acoustiques et comprenant au moins les dispositifs de transduction électroacoustiques ;
• des moyens d'interconnexion permettant de raccorder électriquement lesdits dispositifs de transduction ;
les substrats, référencés dans un repère orthonormé initial (X, Y, Z) avec Z parallèle à l'axe optique, X défini par la piézoélectricité du cristal et Y perpendiculaire à (X, Z), ayant leur plan de coupe identique et une orientation cristalline commune, ledit plan de coupe étant identifié par deux angles de rotation successifs ϕ et θ, ϕ correspondant à une première rotation autour de l'axe Z, le repère obtenu ainsi étant noté (X', Y', Z') avec Z' confondu avec Z, θ représentant une seconde rotation autour de l'axe X', le repère obtenu ainsi étant noté (X", Y", Z"), avec X" confondu avec X' ; la direction de propagation des ondes acoustiques étant définie par un troisième angle ψ pris dans ledit repère (X", Y", Z") représentant une rotation autour de l'axe Y", **caractérisé en ce que**, pour toute direction de propagation ψ :
les angles de coupe (ϕ, θ) sont compris dans l'une des deux plages angulaires suivantes appelées coupe (0, 0, 0)ₐ et coupe (60, 0, 0)ₐ :
- coupe (0, 0, 0)ₐ - 5° ≤ ϕ ≤ + 5°
- 20° ≤ θ ≤ + 30°
- coupe (60, 0, 0)ₐ + 55° ≤ ϕ ≤ + 65°
- 30° ≤ θ ≤ + 20°

2. Dispositif à ondes acoustiques selon la revendication 1, **caractérisé en ce que** les angles (ϕ, θ, ψ) pris dans le repère (X", Y", Z") sont compris dans l'une des deux plages angulaires suivantes appelées coupe (0, 0, 0)_{b} et coupe (60, 0, 0)_{b} :
- coupe (0, 0, 0)_{b} - 5° ≤ ϕ ≤ + 5°
- 10° ≤ θ ≤ +10°
- 5° ≤ ψ ≤ +5°
- coupe (60, 0, 0)_{b} + 55° ≤ ϕ ≤ + 65°
- 10° ≤ θ ≤ + 10°
- 5° ≤ ψ ≤ +5°

3. Dispositif selon l'une des revendications 1 ou 2, **caractérisé en ce que** les épaisseurs des deux substrats sont grandes devant la longueur d'onde acoustique d'utilisation (λ) et l'épaisseur de la zone d'interface est faible devant la longueur d'onde acoustique d'utilisation (λ).

4. Dispositif selon l'une des revendications 1, 2 ou 3, **caractérisé en ce que** la zone d'interface se présente sous la forme d'une structure stratifiée comprenant au moins les dispositifs de transduction électro-acoustiques ainsi qu'une ou plusieurs couches de matériau diélectrique.

5. Dispositif selon l'une des revendications 1, 2 ou 3, **caractérisé en ce que** la zone d'interface comprend uniquement les dispositifs de transduction électro-acoustiques qui sont alors gravés sur une des deux surfaces des substrats en contact, ladite zone d'interface étant alors réduite à un plan d' interface.

6. Dispositif selon l'une des revendications précédentes, **caractérisé en ce que** ledit dispositif est un composant passif de type résonateur ou filtre ou ligne à retard ou dispositif à code de phase.

7. Capteur de mesure composé d'une chaîne de dispositifs **caractérisé en ce que** ladite chaîne comprend au moins un dispositif selon l'une des revendications précédentes.

8. Dispositif fonctionnant suivant le principe des codes de phase et composé d'une chaîne de dispositifs **caractérisé en ce que** ladite chaîne comprend au moins un dispositif selon l'une des revendications précédentes.

## Patentansprüche

1. Vorrichtung mit akustischen Grenzflächenwellen, die aufweist:
• ein erstes kristallines Substrat (S₁) aus Lithiumtantalat (LiTaO₃);
• ein zweites kristallines Substrat (S₂) ebenfalls aus Lithiumtantalat;
• zusammengesetzt durch eine ebene Grenzflächenzone (I), die zur Ausbreitung der akustischen Wellen dient und mindestens die elektroakustischen Transduktionsvorrichtungen enthält;
• Zusammenschaltungsmittel, die es ermöglichen, die Transduktionsvorrichtungen elektrisch anzuschließen;
wobei die Substrate, die in einem ursprünglichen orthonormalen Koordinatensystem (X, Y, Z) bezeichnet sind, mit Z parallel zur optischen Achse, X durch die Piezoelektrizität des Kristalls definiert, und Y lotrecht zu (X, Z), eine identische Schnittebene und eine gemeinsame kristalline Ausrichtung haben, wobei die Schnittebene durch zwei aufeinanderfolgende Drehwinkel ϕ und θ identifiziert wird, wobei ϕ einer ersten Drehung um die Achse Z entspricht, wobei das so erhaltene Koordinatensystem mit (X', Y', Z') bezeichnet wird, wobei Z' mit Z zusammenfällt, θ eine zweite Drehung um die Achse X' darstellt, wobei das so erhaltene Koordinatensystem mit (X", Y", Z") bezeichnet wird, wobei X" mit X' zusammenfällt; wobei die Ausbreitungsrichtung der akustischen Wellen durch einen dritten Winkel ψ im Koordinatensystem (X", Y", Z") definiert wird, der eine Drehung um die Achse Y" darstellt, **dadurch gekennzeichnet, dass** für jede Ausbreitungsrichtung ψ:
die Schnittwinkel (ϕ, θ) in einem der beiden folgenden Winkelbereiche liegen, die Schnitt (0, 0, 0)ₐ und Schnitt (60, 0, O)ₐ genannt werden:
- Schnitt (0, 0, 0)ₐ -5° ≤ ϕ ≤ +5°
-20° ≤ θ ≤ +30°
- Schnitt (60, 0, 0)ₐ +55° ≤ ϕ ≤ +65°
-30° ≤ θ ≤ +20°

2. Vorrichtung mit akustischen Wellen nach Anspruch 1, **dadurch gekennzeichnet, dass** die Winkel (ϕ, θ, ψ) im Koordinatensystem (X", Y", Z") in einem der beiden folgenden Winkelbereiche liegen, die Schnitt (0, 0, 0)_{b} und Schnitt (60, 0, 0)_{b} genannt werden:
- Schnitt (0, 0, 0)_{b} -5° ≤ ϕ ≤ +5°
-10° ≤ θ ≤ +10°
-5° ≤ ψ ≤ +5°
- Schnitt (60, 0, 0)_{b} +55° ≤ ϕ ≤ +65°
-10° ≤ θ ≤ +10°
-5° ≤ ψ ≤ +5°

3. Vorrichtung nach einem der Ansprüche 1 oder 2, **dadurch gekennzeichnet, dass** die Dicken der beiden Substrate gegenüber der akustischen Nutzwellenlänge (λ) groß sind, und die Dicke der Grenzflächenzone gegenüber der akustischen Nutzwellenlänge (λ) gering ist.

4. Vorrichtung nach einem der Ansprüche 1, 2 oder 3, **dadurch gekennzeichnet, dass** die Grenzflächenzone in Form einer geschichteten Struktur vorliegt, die mindestens die elektro-akustischen Transduktionsvorrichtungen sowie eine oder mehrere Schichten aus dielektrischem Material aufweist.

5. Vorrichtung nach einem der Ansprüche 1, 2 oder 3, **dadurch gekennzeichnet, dass** die Grenzflächenzone nur die elektro-akustischen Transduktionsvorrichtungen enthält, die dann auf eine der beiden Flächen der in Kontakt stehenden Substrate eingraviert sind, wobei die Grenzflächenzone dann auf eine Grenzflächenebene reduziert ist.

6. Vorrichtung nach einem der vorhergehenden Ansprüche, **dadurch gekennzeichnet, dass** die Vorrichtung ein passives Bauteil von der Art Resonator oder Filter oder Verzögerungsleitung oder Vorrichtung mit Phasencode ist.

7. Aus einer Kette von Vorrichtungen bestehender Messwertsensor, **dadurch gekennzeichnet, dass** die Kette mindestens eine Vorrichtung nach einem der vorhergehenden Ansprüche aufweist.

8. Vorrichtung, die gemäß dem Prinzip der Phasencodes arbeitet und aus einer Kette von Vorrichtungen zusammengesetzt ist, **dadurch gekennzeichnet, dass** die Kette mindestens eine Vorrichtung nach einem der vorhergehenden Ansprüche aufweist.

## Claims

1. Interface acoustic wave device comprising:
• a first crystal substrate (S₁) made of lithium tantalate (LiTaO₃);
• a second crystal substrate (S₂), also made of lithium tantalate;
• these being joined together via a plane interface region (I) serving for the propagation of acoustic waves and comprising at least the electroacoustic transducer;
• interconnection means for electrically connecting said transducers;
the substrates, referenced in an initial orthonormal coordinate system (X,Y,Z), Z being parallel to the optical axis, X being defined by the piezoelectricity of the crystal and Y being perpendicular to (X,Z), having their identical cut plane and a common crystal orientation, said cut plane being identified by two successive angles of rotation ϕ and θ, ϕ corresponding to a first rotation about the Z axis, the coordinate system obtained thus being denoted by (X',Y',Z') with Z' coincident with Z, and θ representing a second rotation about the X' axis, the coordinate system obtained thus being denoted by (X",Y",Z"), with X" coincident with X', the direction of propagation of the acoustic waves being defined by a third angle ψ taken in said coordinate system (X",Y",Z") representing a rotation about the Y" axis, **characterized in that**, for any direction of propagation ψ:
the cut angles (ϕ,θ) lie within one of the following two angular ranges called the (0,0,0)ₐ cut and the (60,0,0)ₐ:
- (0,0,0)ₐ cut: -5° ≤ ϕ ≤ +5°
-20° ≤ θ ≤ +30°
- (60,0,0)ₐ cut: +55° ≤ ϕ ≤ +65°
-30° ≤ θ ≤ +20°.

2. Acoustic wave device according to Claim 1, **characterized in that** the angles (ϕ,θ,ψ), taken within the (X",Y",Z") coordinate system lie within one of the following two angular ranges called the (0,0,0)_{b} cut and the (60,0,0)_{b} cut:
- (0, 0, 0) _{b} cut: -5° ≤ ϕ ≤ +5°
-10° ≤ θ ≤ +10°
-5° ≤ ψ ≤ +5°
- (60,0,0)_{b} cut: +55° ≤ ϕ ≤ +65°
-10° ≤ θ ≤ +10°
-5° ≤ ψ ≤ +5°.

3. Device according to either of Claims 1 and 2, **characterized in that** the thicknesses of the two substrates are large compared with the operating acoustic wavelength (λ) and the thickness of the interface region is small compared with the operating acoustic wavelength (λ).

4. Device according to one of Claims 1, 2 and 3, **characterized in that** the interface region is in the form of a laminated structure comprising at least the electroacoustic transducers and one or more layers of dielectric material.

5. Device according to one of Claims 1, 2 and 3, **characterized in that** the interface region comprises only the electroacoustic transducers, which are then etched on one of the two surfaces of the substrates in contact with each other, said interface region then being reduced to an interface plane.

6. Device according to one of the preceding claims, **characterized in that** said device is a passive component such as a resonator or a filter or a delay line or a phase code device.

7. Measurement sensor composed of a chain of devices, **characterized in that** said chain comprises at least one device according to one of the preceding claims.

8. Device operating according to the phase code principle and composed of a chain of devices, **characterized in that** said chain comprises at least one device according to one of the preceding claims.
